Europäisches Patentamt

European Patent Office

Office européen des brevets

(11) Veröffentlichungsnummer: **0 121 163**
**B1**

(12) # EUROPÄISCHE PATENTSCHRIFT

(45) Veröffentlichungstag der Patentschrift:
22.06.88

(51) Int. Cl.⁴: **H 05 K 7/20,** F 28 F 21/06

(21) Anmeldenummer: **84102873.1**

(22) Anmeldetag: **15.03.84**

(54) **Wärmeaustauscher für einen Elektronikschrank.**

(30) Priorität: **28.03.83 DE 3311212**

(43) Veröffentlichungstag der Anmeldung:
**10.10.84 Patentblatt 84/41**

(45) Bekanntmachung des Hinweises auf die Patenterteilung:
**22.06.88 Patentblatt 88/25**

(84) Benannte Vertragsstaaten:
**AT BE CH DE FR GB IT LI NL SE**

(56) Entgegenhaltungen:
**DE - A - 3 026 196**
**DE - B - 2 444 864**
**DE - C - 3 045 326**
**GB - A - 1 024 451**
**US - A - 3 798 506**
**US - A - 3 847 211**

(73) Patentinhaber: **Siemens Aktiengesellschaft Berlin und München, Wittelsbacherplatz 2, D-8000 München 2 (DE)**

(72) Erfinder: **Modschiedler, Kurt, Langenbrucker Weg 3, D-8524 Neunkirchen (DE)**

ACTORUM AG

# Beschreibung

Die Erfindung betrifft einen Wärmeaustauscher für einen Elektronikschrank, mit einem Faltflächenprofil aus Kunststoff, bei dem alternierend an beiden Stirnseiten jede zweite Falte mit einer Querabdeckung gasdicht verschlossen ist und die Querabdeckungen einstückig an die Falten angeformt sind und wobei das Faltflächenprofil ein Tiefziehteil ist.

Luft-Luft-Wärmeaustauscher sind aus der DE-AS 20 06 759, der DE-AS 22 31 469, der DE-PS 24 44 864 oder aus der De-OS 30 26 196 bekannt. Die bekannten Wärmeaustauscher, die aus Aluminium oder auch aus Kunststoff gefertigt sein können, besitzen eine Vielzahl von parallel verlaufenden Falten, wobei jede Falte stirnseitig mit einer Querabdeckung versehen ist und die Querabdeckungen benachbarter Falten alternierend an der einen oder der anderen Stirnseite angeordnet sind. Auf den Seitenflächen des Faltflächenprofils sind Platten aufgebracht, mit denen die Falten zu geschlossenen Strömungskanälen abgedeckt werden. Im Bereich der Querabdeckungen sind in diesen Platten Öffnungen für die nach der jeweiligen Seitenfläche offenen Falten vorgesehen. Dann erhält man zwei getrennte Strömungswege für die Schrankluft und für die Außenluft, in denen die Strömung im Faltflächenprofil gegenläufig ist. Diese Wärmeaustauscher ersetzen einen Teil der Gehäusewand des Elektronikschrankes oder sie können in die Tür des Elektronikschrankes eingefügt werden, und mit ihnen wird die durch elektronische Bauteile im Elektronikschrank erzeugte Wärme abgeführt, wobei der Innenraum des Elektronikschrankes staubdicht abgeschlossen bleibt. Die Fertigung des Faltflächenprofils mit seinen Querabdeckungen ist aufwendig. Beispielsweise in der DE-PS 24 44 864 ist eine Ausführungsform des Faltflächenprofils beschrieben, bei der Blechstreifen mit stirnseitigen Abkantungen aneinandergefügt und zusammen mit den Abdeckplatten verklebt werden. Die miteinander verklebten Abkantungen bilden die Querabdeckungen, das Faltflächenprofil selbst wird mittels der beiden Abdeckplatten gebildet. Um Staubdichtigkeit zu gewährleisten, muß die Verklebung sowohl zwischen den Abkantungen als auch zwischen den Blechstreifen und den Abdeckplatten selbst sehr sorgfältig ausgeführt werden. Außerdem ist für die Aushärtung des Klebers längere Zeit erforderlich. Bei der in der DE-OS 30 26 196 beschriebenen Ausführungsform ist das Faltflächenprofil aus mäanderförmig gebogenem Blech oder mäanderförmig geformtem Kunststoff gebildet. Als Querabdeckungen müssen Blechteile oder entsprechend geformte Kunststoffformteile einzeln an der Stirnfläche angebracht und gegebenenfalls auch mit den Falten verklebt werden. Beide Fertigungsverfahren sind auch bei Serienfertigung sowohl mit einem hohen Personalaufwand als auch mit einem hohen Zeitaufwand verbunden.

Aus der US-PS 3 847 211 ist ein Wärmeaustauscher für gasförmige bzw. flüssige Medien bekannt, die im Gegenstromverfahren gekühlt werden. Der Kühler besteht aus mehreren Faltflächenprofilen aus Kunststoff, bei denen alternierend an beiden Stirnseiten jede zweite Falte einstückig mit einer Querabdeckung verschlossen ist und jedes Faltflächenprofil ein Tiefziehteil ist. Mehrere solche Faltflächenprofile sind unter Zwischenfügung jeweils einer Platte aufeinandergestapelt. Das eine zu kühlende Medium wird geradlinig, das andere Medium seitwärts dem Stapel von Faltflächenprofilen zu- und von ihm abgeführt. Solche Wärmeaustauscher sind zum Einsatz in der Chemie und der medizinischen Technik vorgesehen.

Es besteht die Aufgabe, ein Faltflächenprofil für einen Wärmeaustauscher der eingangs genannten Art so auszubilden, daß es einfach gefertigt werden kann und montagefreundlich ist.

Erfindungsgemäß wird diese Aufgabe dadurch gelöst, daß die Tiefe der Falten etwa das Sechsfache des Abstands zwischen den Faltwänden beträgt und daß an einer Stirnseite des Faltflächenprofils parallel zu seinen Seitenflächen ein plattenförmiger Ansatz vorgesehen ist.

Beim erfindungsgemäßen Wärmeaustauscher sind die Querabdeckungen integraler Bestandteil des Faltflächenprofils, die bei dessen Herstellung angeformt werden. Ein nachträgliches Einbringen gesonderter Formteile oder ein nachträgliches Verkleben von Abkantungen ist daher nicht mehr erforderlich, womit insbesondere bei der Serienfertigung sowohl der Zeit- als auch der Personalaufwand wesentlich gesenkt werden. Zusätzlich genügt es beim Aufbringen der Abdeckplatten eine staubdichte Verbindung längs der Umfangslinie des Faltflächenprofils sicherzustellen, da alle nach einer Seitenfläche des Faltflächenprofils offenen Falten dem gleichen Strömungsweg angehören. Auch dies trägt zu einer wesentlichen Vereinfachung der Fertigung bei. Der plattenförmige Ansatz dient zur Trennung der beiden Strömungswege außerhalb des Faltflächenprofils, womit der Aufbau des gesamten Wärmeaustauschers weiter vereinfacht wird. Außerdem wird dieser Ansatz als Montagefläche benutzt, die für die Aufnahme eines Lüfters und seiner elektrischen Anschlüsse dienen kann. Unter Berücksichtigung des Verhältnisses zwischen Tiefe der Falten und dem Abstand zwischen den Faltwänden des Faltflächenprofils ist auch die Herstellung des Faltflächenprofils im Tiefziehverfahren ohne Schwierigkeiten realisierbar.

Zur Optimierung des Wärmeübergangs zwischen den beiden durch Faltwände getrennten Strömungswegen kann der Abstand zwischen den Faltwänden im Faltflächenprofil in Abhängigkeit von der vorgesehenen Strömungsgeschwindigkeit der Luft in den Falten so gewählt sein, daß sich in den Falten eine turbulente Strömung ausbildet. Die Strömungsturbulenz kann dadurch noch verbessert werden, daß die Faltwände des Faltflächenprofils mit Ausformungen, beispielsweise Noppen oder Stegen versehen sind.

Um den Aufbau von Faltflächenprofilen unterschiedlicher Länge realisieren zu können, kann das Faltflächenprofil aus wenigstens zwei Profilteilen aufgebaut sein, die formschlüssig und gasdicht miteinander verbunden sind. Als vorteilhaft hat es sich erwiesen, die Profilteile über Nut und Feder miteinander zu verbinden. Bei dieser Ausführungsform lassen sich mit zwei Profilteilen, nämlich einem Profilteil, bei dem die Falten integral mit Querabdeckungen versehen sind, und einem Profilteil, bei dem keine Querabdeckungen für die Falten vorhanden sind im Baukastenprinzip Faltflächenprofile beliebiger Länge und damit auch Wärmeaustauscher unterschiedlicher Bauform aufbauen. Dies bietet Vorteile sowohl bei der Herstellung als auch bei der Lagerhaltung.

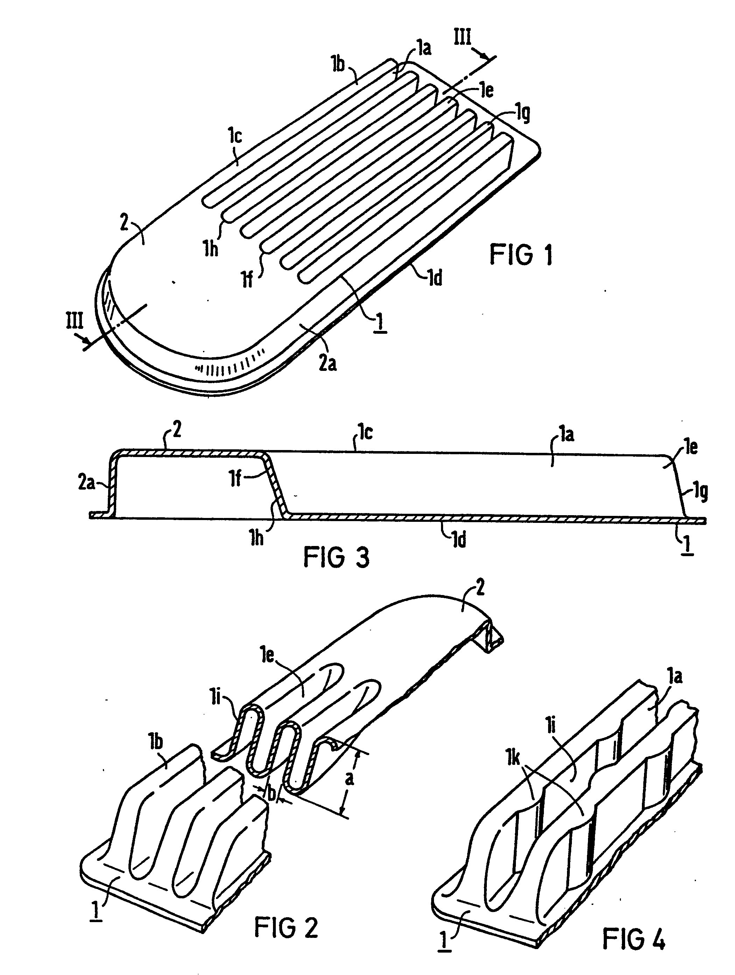

Im folgenden wird der erfindungsgemäße Wärmeaustauscher beispielhaft anhand der Fig. 1 bis 10 näher erläutert. In den Figuren sind gleiche Bauteile mit den gleichen Bezugszeichen versehen.

Fig. 1 zeigt die perspektivische Ansicht eines Faltflächenprofils 1 für einen erfindungsgemäßen Wärmeaustauscher. Das Faltflächenprofil 1 besteht aus einer Vielzahl parallellaufender, im Querschnitt mäanderförmiger Falten 1a und 1b, wobei die Falten 1a nach der Seitenfläche 1c und die Falten 1b nach der in Fig. 1 nicht sichtbaren Seitenfläche 1d des Faltflächenprofils 1 geöffnet sind. An den Stirnseiten 1e und 1f des Faltflächenprofils 1 sind die Falten 1a und 1b alternierend mit Querabdeckungen 1g und 1h abgeschlossen. Damit sind die nach der in Fig. 1 sichtbaren Seitenfläche 1c offenen Falten 1a zumindest staubdicht gegen die nach der rückseitigen Seitenfläche 1d offenen Falten 1b abgedichtet. Im Ausführungsbeispiel nach Fig. 1 ist an das Faltflächenprofil 1 eine Platte 2 angeformt, auf die später näher eingegangen wird. Dieser Aufbau des Faltflächenprofils 1 ist auch der perspektivischen Teilansicht nach Fig. 2 zu entnehmen, bei der man auf die Stirnseite 1e des Faltflächenprofils 1 blickt. In Fig. 2 ist insbesondere der mäanderförmige Querschnitt des Faltflächenprofils mit den parallel verlaufenden Faltenwänden 1i verdeutlicht.

Einen Querschnitt längs der Linie III–III der Fig. 1 zeigt schließlich Fig. 3. Bei diesem Querschnitt ist eine nach der Seitenfläche 1c geöffnete Falte 1a des Faltflächenprofils 1 sichtbar, die mit der Querabdeckung 1h verschlossen ist. Die Falte 1a mündet daher in die Stirnseite 1e. Die benachbarte, nicht sichtbare Falte 1b ist mit der Querabdeckung 1g verschlossen, und Luft kann in diese Falte 1b von der Stirnseite 1f her einströmen.

Das Faltflächenprofil, das anhand der Fig. 1 bis 3 erläutert wurde, entspricht Faltflächenprofilen, wie sie aus den obengenannten Literaturstellen bekannt sind. Es wurde bereits erläutert, daß bei diesen Faltflächenprofilen der Abschluß der Falten durch die Querabdeckungen herstellungsmäßig aufwendig ist. Bei dem in den Fig. 1 bis 3 gezeigten Faltflächenprofil sind diese Herstellungsschwierigkeiten dadurch umgangen, daß die Querabdeckungen 1g und 1h integraler Bestandteil des Faltflächenprofils 1 sind und einstückig an den entsprechenden Stirnflächen 1e und 1f an die Falten 1a und 1b angeformt sind. Bewährt hat es sich, ein solches einstückiges Faltflächenprofil 1 als Tiefziehteil aus Metall oder Kunststoff oder als Kunststoffspritzteil herzustellen. Dabei können einfache, billige Werkzeuge benutzt werden, so daß die Herstellung nicht durch hohe Werkzeugkosten belastet wird. Außerdem können wegen der relativ geringen Werkzeugkosten unterschiedliche Werkzeuge zur Optimierung des Faltflächenprofils 1 erstellt werden, auf die noch näher eingegangen wird.

Insbesondere der Fig. 3 ist zu entnehmen, daß die Querabdeckungen 1g und 1h schräg verlaufen. Damit erhält man für jede Falte 1a und 1b eine sich trichterförmig erweiternde Ein- bzw. Austrittsöffnung, die dem Strömungsquerschnitt des Kühlmittelstroms angepaßt ist und den Strömungswiderstand im Bereich der Ein- bzw. Austrittsöffnen nicht vergrößert. Solche trichterförmigen Ein- bzw. Auslaßöffnungen sind bereits bei dem Faltflächenprofil realisiert, das in der DE-PS 24 44 864 beschrieben ist.

In Fig. 3 ist die Faltentiefe a und der Abstand zwischen zwei Faltwänden 1i mit b bezeichnet. Insbesondere für Tiefziehbauteile hat es sich bewährt, das Faltflächenprofil so zu bemessen, daß die Faltentiefe a etwa das Sechsfache des Abstands b zwischen zwei Faltwänden 1i beträgt. Zur Optimierung des Wärmeübergangs durch die Faltwände 1i von einem Strömungsweg zum anderen ist es außerdem noch günstig, den Abstand b zwischen zwei Faltwänden in Abhängigkeit von der vorgesehenen Strömungsgeschwindigkeit der Luft in der Falte so zu wählen, daß man in der Falte eine turbulente Luftströmung erhält. Die Ausbildung eines Wärmegradienten quer zur Luftströmung wird damit vermieden, was die Wärmeleitung durch die Faltwände 1i optimiert. Außerdem können die Abstände b für die Faltwände bzw. -rippen 1i für die Falten 1a und 1b unterschiedlich sein. Damit läßt sich die im Innen- und Außenkreislauf umgewälzte Luftmenge an die aus dem Schrankinnern abzuführende Abwärme anpassen.

Eine weitere Möglichkeit zur Erhöhung der Strömungsturbulenz zeigt die perspektivische Teilansicht nach Fig. 4. In Fig. 4 sind die Faltwände 1i mit Ausformungen 1k versehen, die in den Strömungsraum der Falte 1a ragen. Mit solchen Ausformungen 1k, die beispielsweise Stege wie im Ausführungsbeispiel oder Noppen sein können, wird die Turbulenz der Strömung in der Falte 1a erhöht. Der Effekt der Turbulenzerhöhung läßt sich noch verbessern, wenn, wie im Ausführungsbeispiel nach Fig. 4 die Ausformungen 1k an gegenüberliegenden Faltwänden 1i versetzt angeordnet sind.

In den Fig. 1 bis 3 ist an das Faltflächenprofil 1 eine Platte 2 angeformt, die mit einer Seitenwand 2a versehen ist, die in der äußeren Faltwand des Faltflächenprofils 1 verläuft. Mit dieser Platte 2 werden die beiden getrennten Strömungswege der Falten 1a und 1b auch außerhalb des Faltflächenprofils 1 getrennt, wobei die Platte 2 als Montagefläche und das mit den Seitenwänden 2a geformte Gehäuse für die Aufnahme eines Lüfters und seiner elektrischen Anschlüsse dienen kann.

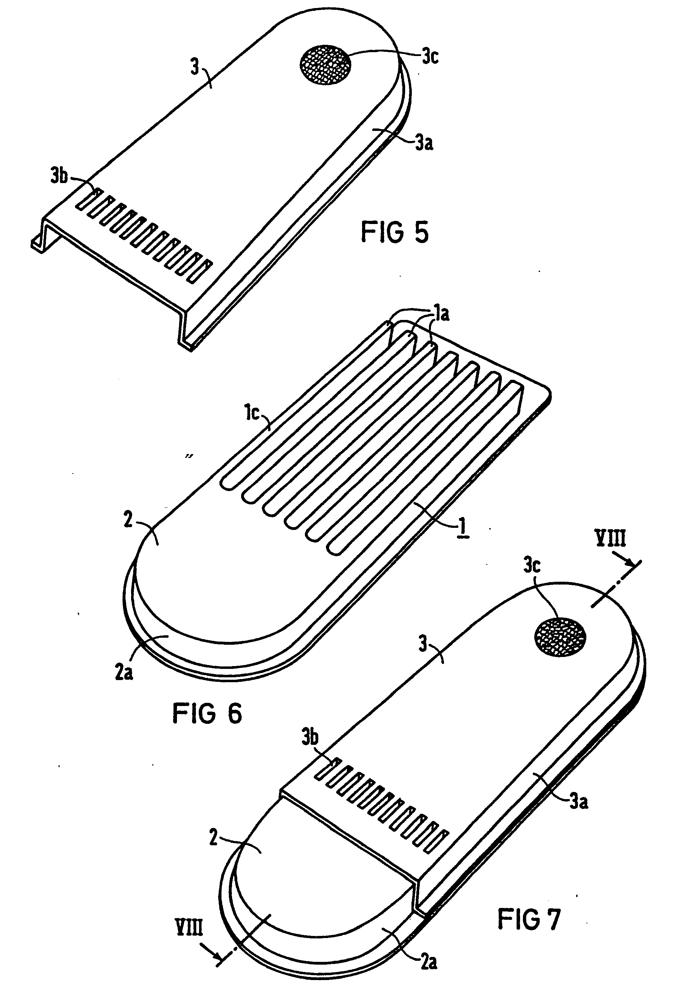

Die Fig. 5 bis 7 verdeutlichen den Aufbau eines erfindungsgemäßen Wärmeaustauschers mit einem Faltflächenprofil gemäß Fig. 1, das in Fig. 6 nochmals gezeigt ist. Zur Abdeckung der Falten 1a ist eine Platte 3 vorgesehen, die mittels Seitenwänden 3a haubenartig ausgestaltet ist. In der auch als Montagehilfe dienenden Platte 3 sind Öffnungen 3b vorgesehen, und in einem Durchbruch 3c ist ein Lüfter angebracht. Entsprechend Fig. 7 wird die Platte 3 auf das Faltflächenprofil 1 aufgesteckt. Die Öffnungen 3b befinden sich im Bereich der Querabdeckungen 1h und liegen über den offenen Falten 1a. Zur staubdichten Verbindung der Abdeckhaube 3 mit dem Faltflächenprofil 1 ist es ausreichend, wenn die Seitenflächen 3a mit den äußeren Faltwänden 1i und die Platte 3 längs der Peripherielinie der Stirnfläche 1f mit dem Wärmeaustauscherprofil 1 gas- bzw. staubdicht verbunden werden. Dies kann durch entsprechende Dichtungsstreifen erfolgen, was ein späteres Abnehmen der Abdeckhaube 3 zur Reinigung der Falten 1a erleichtert. Zur gasdichten Verbindung können die Abdeckhaube 3 und das Faltflächenprofil 1 auch miteinander verklebt sein. Für die Stabilität des Wärmeaustauschers ist es weiterhin günstig, die Querstege zwischen den Faltwänden 1i an der gesamten Seitenfläche 1c des Faltflächenprofils 1 an der Platte 3 zu befestigen.

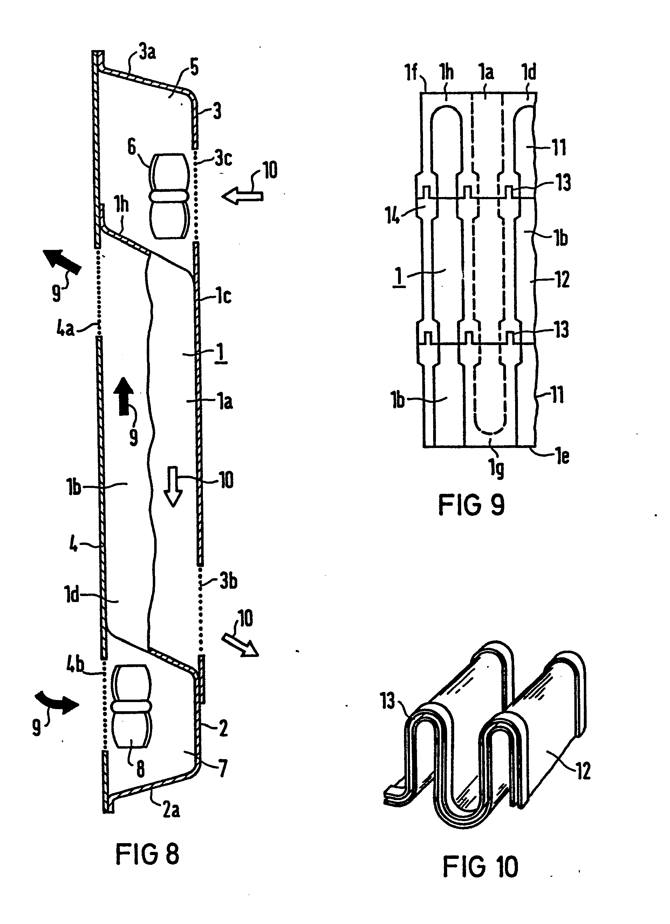

Einen betriebsfertigen erfindungsgemäßen Wärmeaustauscher zeigt schließlich die Fig. 8 im Schnitt. Dabei ist eine Ausführungsform gemäß Fig. 7 gezeigt, wobei auf die Seitenfläche 1d des Faltflächenprofils 1 eine Tragplatte 4 aufgesetzt ist, die über das Faltflächenprofil 1 hinausragt und mit der Seitenwand 3a der Abdeckhaube 3 und mit der Seitenwand 2a der Gehäuseplatte 2 gasdicht verbunden ist. Für die gas- bzw. staubdichte Verbindung der Platte 4 mit dem Faltflächenprofil 1 und mit den Seitenwänden 2a und 3a gelten die Ausführungen zu Fig. 7 entsprechend. Insbesondere ist es günstig, die Seitenwand 3a beispielsweise mit einem Dichtungsstreifen lösbar und gasdicht an der Platte 4 zu befestigen, um eine Abnahme der Abdeckhaube 3 für die Reinigung der Falten 1a zu ermöglichen. In der Tragplatte 4 sind Öffnungen 4a vorgesehen, die im Bereich der Querabdeckungen 1h über den Falten 1b angeordnet sind und diese öffnen. Über eine weitere Öffnung 4b wird schließlich Luft für den zweiten Strömungsweg zugeführt. Mit der Abdeckhaube 3 und der Tragplatte 4 wird ein Gehäuse 5 realisiert, in dem ein Lüfter 6 für einen Luftkreislauf geschaffen ist. Ein ähnliches Gehäuse 7 formt das Gehäuseteil 2 zusammen mit der Tragplatte 4. In diesem Gehäuse 7 ist der Lüfter 8 für den anderen Luftkreislauf, zusammen mit seinen elektrischen Anschlüssen eingebaut. Für die beiden Kreisläufe sei angenommen, daß die Öffnungen 4a und 4b in der Tragplatte 4 in das Schrankinnere münden. Die Führung der Innenraumluft des Elektronikschrankes ist dann mit den Pfeilen 9 angedeutet. Die Schrankinnenluft tritt durch die Öffnung 4b in den Wärmeaustauscher ein, durchströmt die Falten 1b und strömt über die Öffnungen 4a gekühlt wieder in den Schrankinnenraum zurück. Der Kreislauf für die Außenluft ist mit den Pfeilen 10 angedeutet. Die Außenluft tritt durch die Öffnung 3c ein, durchströmt die Falten 1a gegenläufig zum Luftstrom in den Falten 1b und tritt über die Öffnungen 3b wieder in den Außenraum aus. Da die beiden Kreisläufe 9 und 10 gas- bzw. staubdicht voneinander getrennt sind, ist die Abfuhr der Abwärme des Elektronikschrankes bei staubdichtem Verschluß des Elektronikschrankes sichergestellt.

Eine weitere Ausführungsform eines Faltflächenprofiles 1 für einen erfindungsgemäßen Wärmetauscher zeigt die Fig. 9 in Draufsicht auf die Seitenfläche 1d. Bei diesem Ausführungsbeispiel besteht das Faltflächenprofil 1 aus Profilteilen 11 und 12, die über formschlüssige Verbindungen 13 staub- und gasdicht miteinander verbunden sind. Im Ausführungsbeispiel ist als formschlüssige Verbindung eine Nut- und Federverbindung vorgesehen. Bei diesem Ausführungsbeispiel sind die beiden Profilteile 11 im Aufbau identisch, sie besitzen die mit den Falten 1a und 1b integral geformten Abdeckungen 1h und 1g. Das Profilteil 12, das als Zwischenteil eingefügt ist, ist in Fig. 10 in perspektivischer Ansicht dargestellt, womit die Nut- und Federverbindung verdeutlicht werden soll. Mit solchen Profilteilen 11 und 12 können Faltflächenprofile 1 unterschiedlicher Länge im Baukastenprinzip aufgebaut werden, was die Fertigung unterschiedlicher Baugrößen und die Lagerung wesentlich vereinfacht. Bewährt hat es sich, die Profilteile 11 und 12 als Kunstspritzteile zu fertigen. Die Verdickungen 14 im Bereich der formschlüssigen Verbindung 13 dienen zusätzlich noch zur Erhöhung der Turbulenz der Strömung, wie es im Zusammenhang mit Fig. 4 näher erläutert wurde.

**Patentansprüche**

1. Wärmeaustauscher für einen Elektronikschrank, mit einem Faltflächenprofil aus Kunststoff, bei dem alternierend an beiden Stirnseiten jede zweite Falte mit einer Querabdeckung gasdicht verschlossen ist und die Querabdeckungen einstückig an die Falten angeformt sind und wobei das Faltflächenprofil ein Tiefziehteil ist, dadurch gekennzeichnet, daß die Tiefe (a) der Falten (1a, 1b) etwa das Sechsfache des Abstands (b) zwischen den Faltwänden (1i) beträgt und daß an einer Stirnseite (1f) des Faltflächenprofils (1) parallel zu seinen Seitenflächen (1c, 1d) ein plattenförmiger Ansatz (2) vorgesehen ist.

2. Wärmeaustauscher nach Anspruch 1 mit einer Abdeckung für eine der Seitenflächen des Faltflächenprofils, dadurch gekennzeichnet, daß die Abdeckung (3) mit einem plattenförmigen Ansatz versehen ist.

3. Wärmeaustauscher nach Anspruch 1, dadurch gekennzeichnet, daß das Faltflächenprofil (1) aus wenigstens zwei Profilteilen (11, 12) aufgebaut ist, die formschlüssig und gasdicht (13) miteinander verbunden sind.

4. Wärmeaustauscher nach Anspruch 3, dadurch gekennzeichnet, daß die Profilteile (11, 12) über Nut und Feder miteinander verbunden (13) sind.

5. Wärmeaustauscher nach einem der Ansprüche 1 bis 4, dadurch gekennzeichnet, daß die Faltwände (1i) mit Ausformungen (1k) versehen sind.

6. Wärmeaustauscher nach einem der Ansprüche 1 bis 5, dadurch gekennzeichnet, daß der Abstand (b) zwischen den Faltwänden (1i) im Faltflächenprofil (1) in Abhängigkeit von der vorgesehenen Strömungsgeschwindigkeit der Luft in der Falte (1a, 1b) so gewählt ist, daß sich in den Falten (1a, 1b) eine turbulente Strömung ausbildet.

**Claims**

1. Heat exchanger for an electronics cabinet, having a folded surface profile of synthetic material, in which alternately on both ends each second fold is closed in a gas-tight manner with a transverse cover and the transverse covers are formed in one piece on the folds and the folded surface profile is a deep-drawn part, characterised in that the depth (a) of the folds (1a, 1b) is about six times the distance (b) between the fold walls (1i) and that a plate-like extension (2) is provided on one end (1f) of the folded surface profile (1) parallel to its side faces (1c, 1d).

2. Heat exchanger according to claim 1 having a cover for one of the side faces of the folded surface profile, characterised in that the cover (3) is provided with a plate-like extension.

3. Heat exchanger according to claim 1, characterised in that the folded surface profile (1) is built up out of at least two profiled portions (11, 12) which are connected with each other in a form-fitting and gas-tight manner (13).

4. Heat exchanger according to claim 3, characterised in that the profiled portions (11, 12) are connected (13) with each other by way of groove and tongue.

5. Heat exchanger according to one of the claims 1 to 4, characterised in that the fold walls (1i) are provided with protrusions (1k).

6. Heat exchanger according to one of the claims 1 to 5, characterised in that the distance (b) between the fold walls (1i) in the folded surface profile (1) is selected according to the intended flow velocity of the air in the fold (1a, 1b) so that turbulent flow develops in the folds (1a, 1b).

## Revendications

1. Echangeur de chaleur pour une armoire électronique, comportant un profilé de surface plissé en matière plastique, dans lequel, en alternance sur les deux côtés frontaux, chaque second pli est fermé d'une manière étanche au gaz par un revêtement transversal et les revêtements transversaux sont formés par façonnage d'un seul tenant sur les plis, et dans lequel le profilé de surface plissé est une pièce emboutie, caractérisé par le fait que la profondeur (a) des plis est égale approximativement au sextuple de la distance (b) entre les parois (1i) des plis et qu'une partie saillante en forme de plaque (2) est prévue sur un côté frontal (1f) du profilé de surface plissé (1), parallèlement aux faces latérales 1c, 1d de ce dernier.

2. Echangeur de chaleur suivant la revendication 1, comportant un revêtement pour l'un des côtés frontaux du profilé de surface plissé, caractérisé par le fait que le revêtement (3) comporte une partie saillante en forme de plaque.

3. Echangeur de chaleur suivant la revendication 1, caractérisé par le fait que le profilé de surface plissé (1) est constitué par au moins deux éléments profilés (11, 12), qui sont reliés entre eux selon une liaison par formes complémentaires et d'une manière étanche au gaz (13).

4. Echangeur de chaleur suivant la revendication 3, caractérisé par le fait que les éléments profilés (11, 12) sont reliés entre eux (13) selon un assemblage par rainure et languette.

5. Echangeur de chaleur suivant l'une des revendications 1 à 4, caractérisé par le fait que les parois (1i) des plis comportent des parties renflées (1k).

6. Echangeur de chaleur suivant l'une des revendications 1 à 5, caractérisé par le fait que la distance (b) entre les parois (1i) des plis dans le profilé de surface plissé (1) est choisie en fonction de la vitesse prévue d'écoulement de l'air dans les plis (1a, 1b), de manière qu'il se forme un écoulement turbulent entre les plis (1a, 1b).

FIG 1

FIG 3

FIG 2

FIG 4

FIG 5

FIG 6

FIG 7

**FIG 8**

**FIG 9**

**FIG 10**